(19) Europäisches Patentamt
European Patent Office
Office européen des brevets

(11) **EP 3 260 849 A1**

(12) **EUROPEAN PATENT APPLICATION**

(43) Date of publication:
**27.12.2017 Bulletin 2017/52**

(51) Int Cl.:
*G01N 23/04* (2006.01)      *H01B 13/34* (2006.01)

(21) Application number: **17176924.3**

(22) Date of filing: **20.06.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **23.06.2016 US 201615190347**

(71) Applicant: **General Electric Company Schenectady, NY 12345 (US)**

(72) Inventors:
• DEHGHAN NIRI, Ehsan
  Schenectady, NC North Carolina 12345-6000 (US)
• BREZNAK, Jeffrey Michael
  Schenectady, NY New York 12345-6000 (US)
• MURPHY, Gene
  Schenectady, NY New York 12345-6000 (US)

(74) Representative: **Foster, Christopher Michael et al General Electric Technology GmbH GE Corporate Intellectual Property Brown Boveri Strasse 7 5400 Baden (CH)**

(54) **DISTRIBUTED SENSOR NETWORK FOR NONDESTRUCTIVELY MONITORING AND INSPECTING INSULATED ELECTRICAL MACHINE COMPONENTS**

(57)      An insulated electrical component (10) of an insulated electrical machine includes a conducting element (12), a first radiographically-visible conductor sensor node (16) coupled to the conducting element (12), at least one second radiographically-visible conductor sensor node (16) coupled to the conducting element (12) a first distance in a predetermined direction from the first radiographically-visible conductor sensor node (16), and an insulating material (14) bonded to the conducting element (12). In some embodiments, the insulated electrical component (10) further includes a first radiographically-visible insulator sensor node (40) coupled to the insulating material (14) and not coupled to the conducting element (12) and at least one second radiographically-visible insulator sensor node (40) coupled to the insulating material (14) and not coupled to the conducting element (12) a second distance from the first radiographically-visible insulator sensor node (40). The radiographically-visible sensor nodes (16, 40) are distinguishable from the conducting element (12) and the insulating material (14) in a radiographic image. Methods of manufacturing and non-destructive testing of insulated electrical components (10) are also disclosed.

**FIG. 5**

## Description

FIELD OF THE INVENTION

The present embodiments are directed to insulated electrical components of electrical machines, methods of non-destructive testing, and methods of manufacturing. More specifically, the present embodiments are directed to insulated electrical components with sensor nodes, methods of radiographically detecting creep or debonding in electrical components, and methods of manufacturing insulated electrical components.

BACKGROUND OF THE INVENTION

Creep and debonding are common issues in insulated copper of high-voltage generator components. Creep generally refers to the tendency of a solid material to deform slowly under stress. In high-voltage generator components, creep refers to a slow elongation of a conductive material under high voltage stress. Debonding generally refers to the failure of an adhesive or matrix in a layered component, leading to a debond in the layered component. In high-voltage generator components, debonding refers to a bonding failure of an adhesive or matrix between a conductive material and an insulating material. Such insulated copper is conventionally designed to withstand specific thermal loading and expansion, but creep in the component causes a deformation of the copper over time, in the form of an elongation, that exceeds the design value, which in turn ultimately results in structural failure. Furthermore, this elongation in the insulated copper component may result in debonding between the copper and the insulating material. The debonding region is a significant source of progressive partial discharge and failure in high voltage generator components.

A partial discharge is a localized dielectric breakdown of an electrical insulation system of an insulated electrical machine that does not bridge the space between two conductors. A partial discharge generates high-frequency transient current pulses that persist for a time period in the range of nanoseconds up to a microsecond. Partial discharges cause progressive deterioration of insulating materials, ultimately leading to an electrical breakdown. The magnitude of a partial discharge is related to the extent of damaging discharges occurring, and therefore is related to the amount of damage being inflicted on the insulating material.

BRIEF DESCRIPTION OF THE INVENTION

Creep and debonding are common issues in insulated copper components of electrical machines, such as high-voltage generators. The methods and systems disclosed herein non-destructively measure, inspect, and monitor such components for creep and debonding during the service and manufacturing. A system may benefit, because insulation debond may be determined more accurately, resulting in the development of better production processes. Furthermore, the method results in a very fast in-service inspection of debonding in particular in the end winding connector rings area. Also, creep may be determined without removing insulation, with less effort and quicker turnaround if excessive creep is suspected. Overall, the system may benefit from both a better production process and shorter inspection downtimes.

In an embodiment, a method of non-destructive testing includes collecting a first radiographic image of an insulated electrical component of a predetermined service age. The insulated electrical component includes a conducting element, an insulating material covering the conducting element, a first radiographically-visible conductor sensor node coupled to the conducting element, and at least one second radiographically-visible conductor sensor node coupled to the conducting element spaced a first distance in a predetermined direction from the first radiographically-visible conductor sensor node at the predetermined service age. The method also includes measuring the first distance in the predetermined direction from the first radiographically-visible conductor sensor node to the second radiographically-visible conductor sensor node from the first radiographic image. The method also includes comparing the first distance to a second distance in the predetermined direction from the first radiographically-visible conductor sensor node to the second radiographically-visible conductor sensor node measured from a second radiographic image collected at a pre-service age to determine an occurrence of creep in the insulated electrical component. The first distance being greater than the second distance indicates the occurrence of creep in the insulated electrical component.

In another embodiment, a method of non-destructive testing includes collecting at least one radiographic image of an insulated electrical component of a predetermined service age. The insulated electrical component includes a conducting element, an insulating material covering the conducting element, a first radiographically-visible conductor sensor node coupled to the conducting element, at least one second radiographically-visible conductor sensor node coupled to the conducting element spaced a first distance in a predetermined direction from the first radiographically-visible conductor sensor node at the predetermined service age, a first radiographically-visible insulator sensor node coupled to the insulating material and not coupled to the conducting element, and at least one second radiographically-visible insulator sensor node coupled to the insulating material and not coupled to the conducting element and located a second distance in the predetermined direction from the first radiographically-visible insulator sensor node at the predetermined service age. The method also includes comparing the first distance to the second distance from the first radiographic image to determine an occurrence of debonding in the insulated electrical component. The first distance differing from the second distance indicates the occurrence of debonding in the insulated electrical component.

In another embodiment, a method of manufacturing an insulated electrical component includes coupling a first radiographically-visible conductor sensor node to a conducting element. The method also includes coupling at least one second radiographically-visible conductor sensor node to the conducting element a first distance in a predetermined direction from the first radiographically-visible conductor sensor node. The radiographically-visible conductor sensor nodes are distinguishable from the conducting element and the insulating material in a radiographic image. The method further includes bonding an insulating material to the conducting element and the radiographically-visible conductor sensor nodes.

In another embodiment, an insulated electrical component includes a conducting element, a first radiographically-visible conductor sensor node coupled to the conducting element, at least one second radiographically-visible conductor sensor node coupled to the conducting element a first distance in a predetermined direction from the first radiographically-visible conductor sensor node, and an insulating material bonded to the conducting element. The first radiographically-visible conductor sensor node and the second radiographically-visible conductor sensor node are distinguishable from the conducting element and the insulating material in a radiographic image.

Other features and advantages of the present invention will be apparent from the following more detailed description, taken in conjunction with the accompanying drawings which illustrate, by way of example, the principles of the invention.

BRIEF DESCRIPTION OF THE DRAWINGS

FIG. 1 is a schematic cross sectional end view of an insulated electrical component for creep inspection.

FIG. 2 is a schematic cross sectional top view of the insulated electrical component along line 1-1 of FIG. 1.

FIG. 3 is a schematic view of a radiographic image of area 2 of the insulated electrical component of FIG. 2 exhibiting no creep.

FIG. 4 is a schematic view of a radiographic image of area 2 of the insulated electrical component of FIG. 2 exhibiting creep.

FIG. 5 is a schematic cross sectional end view of an insulated electrical component for creep and debonding inspection.

FIG. 6 is a schematic cross sectional top view of the insulated electrical component along line 3-3 of FIG. 5.

FIG. 7 is a schematic cross sectional side view of the insulated electrical component along line 4-4 of FIG. 5.

FIG. 8 is a schematic view of a radiographic image of area 5 of the insulated electrical component of FIG. 6 exhibiting no creep or debonding.

FIG. 9 is a schematic cross sectional side view of the insulated electrical component of FIG. 5 exhibiting creep but no debonding.

FIG. 10 is a schematic view of a radiographic image of area 5 of the insulated electrical component of FIG. 6 in the state of FIG. 9.

FIG. 11 is a schematic cross sectional side view of the insulated electrical component of FIG. 5 exhibiting creep and debonding.

FIG. 12 is a schematic view of a radiographic image of area 5 of the insulated electrical component of FIG. 6 in the state of FIG. 11.

Wherever possible, the same reference numbers will be used throughout the drawings to represent the same parts.

DETAILED DESCRIPTION OF THE INVENTION

Provided are methods and systems for non-destructive testing and monitoring for creep and debonding in insulated components of electrical machines to determine a damage state of the electrical component.

Embodiments of the present disclosure, for example, in comparison to concepts failing to include one or more of the features disclosed herein, nondestructively detect creep in insulated conducting components of electrical machines, nondestructively detect debonding in insulated conducting components of electrical machines, detect a damage state prior to failure to avoid failure in insulated conducting components of electrical machines, permit radiographic monitoring of insulated electrical components for detection of creep or debonding, or combinations thereof.

In some embodiments, the electrical machine is a high-voltage generator. As used herein, a high-voltage generator is a generator producing a voltage of 100 kV or higher.

As used herein, a conductor sensor node refers to a sensor node coupled to move with a conducting element. The conductor sensor node itself may be conductive or nonconductive.

As used herein, an insulator sensor node refers to a sensor node coupled to move with insulating material. The insulator sensor node itself may be conductive or nonconductive.

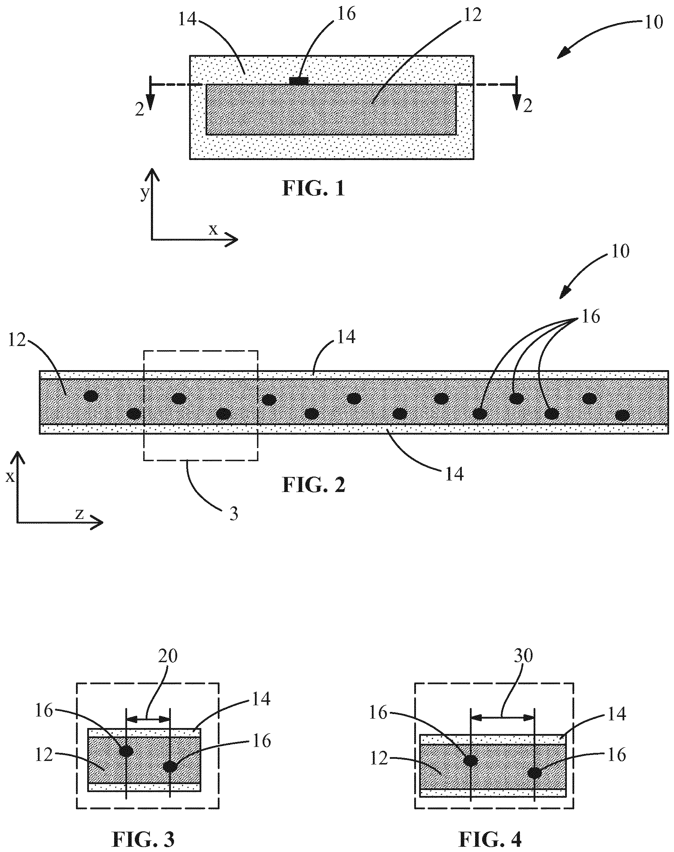

For creep detection, the insulated electrical component 10 includes a conducting element 12 surrounded by insulating material 14, as shown in FIG. 1 and FIG. 2. At least two conductor sensor nodes 16 are coupled to the surface of the conducting element 12 at different locations along the length of the conducting element 12 for monitoring of creep in the insulated electrical component 10. After manufacture but prior to service, the insulated electrical component 10 may be inspected by radiographic imaging to measure a first sensor distance 20 ($L_1$) between conductor sensor nodes 16, as shown in FIG. 3. In some embodiments, the radiographic imaging is X-ray imaging. In some embodiments, the distance 20 is determined by counting pixels on the radiograph and dividing by the pixel density after calibration. At one or more predetermined times during service, the insulated electrical component 10 is inspected by radiographic imaging to measure a second sensor distance 30 ($L_2$) in the same direction as the first sensor distance 20 between conductor sensor nodes 16, as shown in FIG. 4. The creep ($\varepsilon_c$) of the conducting element 12 is defined by equation (1):

$$\varepsilon_c = \frac{L_2 - L_1}{L_1}$$

$$(1)$$

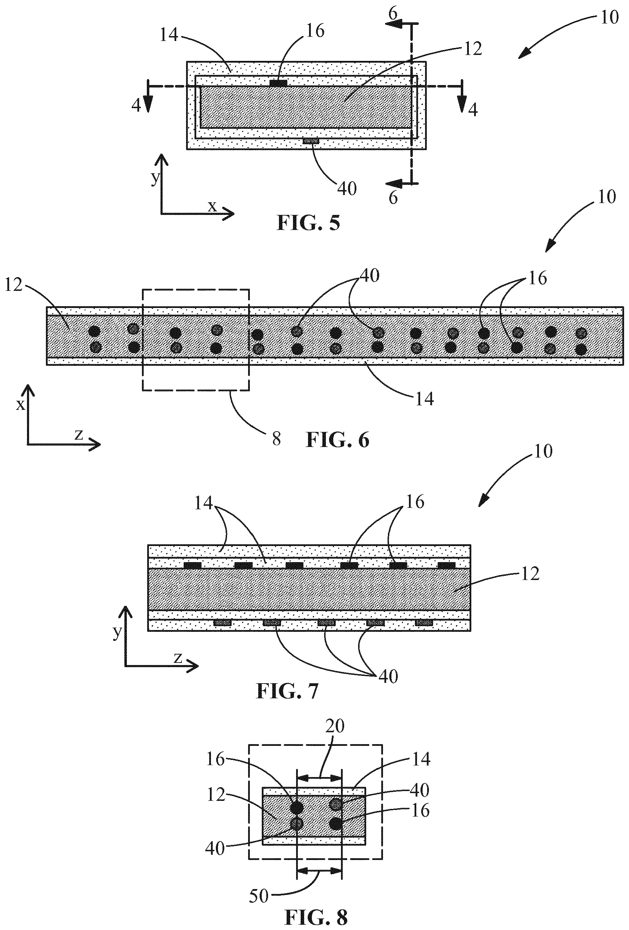

For debonding detection, the insulated electrical component 10 includes a conducting element 12 surrounded by insulating material 14 bonded to the conducting element 12, as shown in FIG. 5 and FIG. 6. At least two conductor sensor nodes 16 are coupled to the surface of the conducting element 12 at different locations along the length of the conducting element 12, and at least two insulator sensor nodes 40 are located within the insulating material 14 but not coupled to the conducting element 12. In some embodiments, the insulator sensor nodes 40 are located between two layers of insulating material 14, as shown in FIG. 7. In some embodiments, each conductor sensor node 16 has a corresponding insulator sensor node 40 at a corresponding same location relative to the conductor sensor node 16 at the time of manufacture. As such, at the time of manufacture, a first sensor distance 20 ($L_1$) between conductor sensor nodes 16 is equal to a first sensor distance 50 ($L_3$) between the corresponding insulator sensor nodes 40, as shown in FIG. 8.

After manufacture but prior to service, the insulated electrical component 10 may be inspected by radiographic imaging to document the locations of the conductor sensor nodes 16 and measure the first sensor distances 20 between conductor sensor nodes 16 and to document the locations of the insulator sensor nodes 40 and measure the first sensor distances 50 between insulator sensor nodes 40, as shown in FIG. 8. In some embodiments, the radiographic imaging is X-ray imaging. Since the spacing of the conductor sensor nodes 16 is the same as the spacing of the insulator sensor nodes 40, $L_1$ is equal to $L_3$.

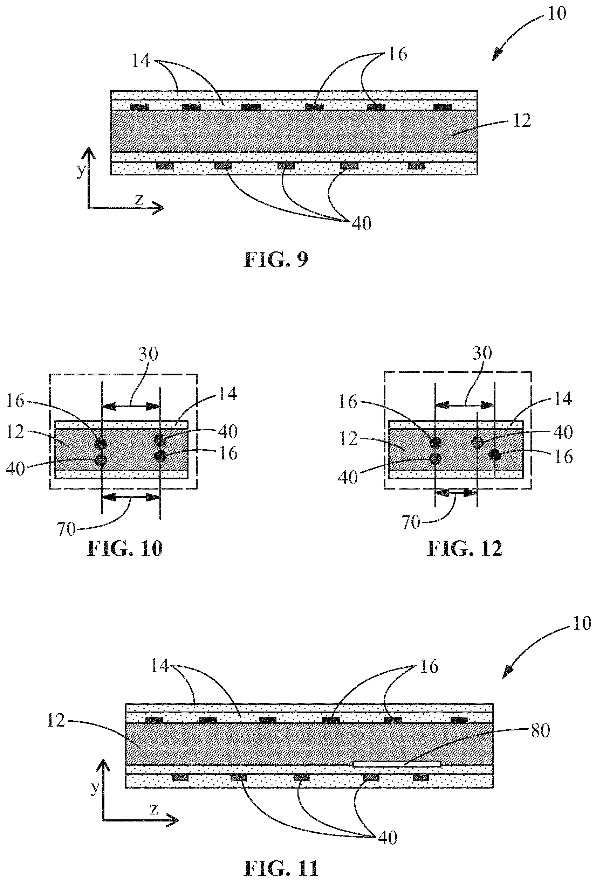

At one or more predetermined times during service, the insulated electrical component 10 is inspected by radiographic imaging. FIG. 9 schematically shows the insulated electrical component 10 in a state where creep has occurred but no debonding has occurred. Although the second sensor distance 30 between conductor sensor nodes 16 is greater than the first sensor distance 20, and the second sensor distance 70 ($L_4$) between insulator sensor nodes 40 is greater than the first sensor distance 50, as shown in FIG. 10, the second sensor distances 30, 70 are still equal to each other, indicating creep but no debonding. In other words, when the creep ($\varepsilon_c$) for the conducting element 12 equals the "creep" ($\varepsilon_i$) for the insulating material 14, no debonding has occurred, where the creep ($\varepsilon_c$) for the conducting element 12 is defined by equation (1), and the "creep" ($\varepsilon_i$) for the insulating material 14 is defined by equation (2):

$$\varepsilon_i = \frac{L_4 - L_3}{L_3}$$

$$(2)$$

When the insulator sensor node 40 no longer aligns with the corresponding conductor sensor node 16, debonding has occurred. FIG. 11 schematically shows the insulated electrical component 10 in a state where both creep and debonding 80 have occurred. Referring to the schematic radiographic image of FIG. 12, the second sensor distance 30 between conductor sensor nodes 16 is now greater than the second sensor distance 70 between insulator sensor nodes 40. Therefore, the creep ($\varepsilon_c$) for the conducting element 12 is greater than the "creep" ($\varepsilon_i$) for the insulating material 14. Debonding between the insulating material 14 and the conducting element 12 has occurred, because the radiographic image shows that the conducting element 12 has elongated more than the insulating material 14. In contrast to creep detection where the first distance 20 must be known, neither the starting distances 20, 50 between sensors nor the absolute distances 30, 70 need known for debonding detection. In some embodiments, a qualitative determination regarding debonding may be made merely by visual inspection of the radiograph to determine whether the conductor sensor nodes 16 align with the insulator sensor nodes 40. In mathematical terms, the length ratio ($R_L$) equals one when no debonding has occurred at either node, whereas $R_L$ being not equal to one indicates that debonding has occurred at one or both nodes, where $R_L$ is defined only in terms of the ratio of the current sensor distances 30, 70 as in equation (3):

$$R_L = \frac{L_4}{L_2}$$

$$(3)$$

Although the distances in FIG. 3, FIG. 4, FIG. 8, FIG. 10, and FIG. 12 are shown as being measured in the z-direction, any predetermined direction may be chosen for creep and debonding detection, including, the x-direction, the y-direction, and the z-direction, as defined in FIG. 5 and FIG. 6, or any direction therebetween.

In some embodiments, the non-destructive testing occurs on an electrical machine *in situ.* In some embodiments, the *in situ* non-destructive testing or monitoring identifies problems long before an eventual failure. In other embodiments, the non-destructive testing occurs during a time at which the electrical machine may be off-line or shut down or during production of the electrical machine or a component of the electrical machine for quality control or inspection purposes. In some embodiments, the non-destructive testing occurs during factory/outage high-potential (hipot) testing and insulation quality control (QC) testing. Hipot testing, as used herein, refers to a class of electrical tests to verify the condition of the electrical insulation in an electrical system. In some embodiments, hipot testing involves applying a high voltage and monitoring the resulting current flowing through the insulation to determine whether the insulation is sufficient to protect from electrical shock. In some embodiments, insulation quality control radiographic data is collected. This data may be used to supplement a hipot test. In some embodiments, the non-destructive testing occurs in-service during an outage.

The conducting element 12 may be made of any known conductive material. The conductive material is preferably a conductive material able to accommodate high voltages. In some embodiments, the conductive material is copper. In some embodiments, the conducting element 12 is a smart conductive element with conductor sensor nodes 16 affixed to the surface of the conductive material at the time of manufacture. The conductor sensor nodes 16 are preferably located in a regular pattern on the conducting element 12. In some embodiments, the conductor sensor nodes 16 are only or specifically located on portions of the conducting element 12 known to be prone to creep and/or debonding.

The insulating material 14 may be any known insulating material 14 or combination of insulating materials 14 that may be bonded to the conducting element 12. The insulating material 14 is preferably able to insulate a conductive material conducting high voltages. In some embodiments, the insulating material 14 is smart insulation with insulator sensor nodes 40 embedded in the insulating material 14 at the time of manufacture. The insulator sensor nodes 40 are preferably embedded as close as possible to the bonding surface without being themselves bonded to the conducting element 12. In some embodiments, the insulator sensor nodes 40 are embedded within a predetermined distance of the insulating material 14 surface to be bonded to the conducting element 12. The predetermined distance is preferably selected based on the imaging system and equipment to provide adequate radiographic detection and to not disrupt or hinder the function of the insulated component.

The conductor sensor nodes 16 and insulator sensor nodes 40 may be made of any material or materials having radiographic contrast with the conducting element 12 and the insulating material 14 that is able to be attached to the conducting element 12 or the insulating material 14, respectively, and that negligibly affects conduction and bonding in the insulated electrical component 10. As such, the conductor sensor nodes 16 and insulator sensor nodes 40 are smart sensors that are radiographically detectable in the insulated electrical component 10 without disrupting the function of the insulated electrical component 10. In some embodiments, the smart sensors are completely passive sensors that are detectable merely by radiographical imaging to indicate their location, from which the creep and debonding state of the insulated electrical component 10 may be determined. In some embodiments, the sensor material has a different density from the conductive material and the insulating material 14. The conductor sensor nodes 16 may be made of the same or different materials from the materials of the insulator sensor nodes 40. Sensor materials may include, but are not limited to, a plastic material, a composite material, a poorly-conducting metal material, or combinations thereof. In some embodiments, the sensors may be defined as a void or lack of material. In some embodiments, the conductor sensor nodes 16 and insulator sensor nodes 40 have a predetermined shape to make them more distinguishable in a radiographic image.

The conductor sensor nodes 16 are preferably relatively small and flat to minimize disruption of electrical current and to minimize disruption of bonding between the conducting element 12 and the insulating material 14.

In some embodiments, the insulated electrical component 10 is a high-voltage generator component. Nondestructive measurement of creep by a reliable creep inspection method, as disclosed herein, during the routine service maintenance of a system may avoid a failure caused by creep or debonding in the system. In some embodiments, the method inspects insulated copper components in an electrical machine for creep. In some embodiments, the method inspects insulated copper components in an electrical machine for creep and for debonding. In some embodiments, the pattern of the sensor nodes 16, 40 may be built or printed using high/low density to keep track of the insulated electrical component 10 deformation caused by creep or debonding. The geometric information, such as location and distance between these sensor nodes 16, 40, may be measured using radiographic imaging. Creep may be simply monitored by recording and keeping track of the sensor coordinates at different times after service of the insulated electrical component 10. In addition, based on the boundary condition constraint between the insulating material 14 and the conducting element 12 and the fact that the strain in the boundary between the insulating material 14 and conducting element 12 is equal while they are bonded, these sensor nodes 16, 40 may be located at different levels where debonding is a concern. Having the X-ray image of the insulated electrical component 10 during the manufacturing and comparing the X-ray image during the service, one may easily determine the location and the debonding state. Overall, the strain and debonding may be measured during the life of the insulated electrical component 10 non-destructively using radiographic imaging and patterns of internally-embedded sensor nodes 16, 40.

While the invention has been described with reference to one or more embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified.

Various aspects and embodiments of the present invention are defined by the following clauses:

1. A method of non-destructive testing, the method comprising:

collecting a first radiographic image of an insulated electrical component of a predetermined service age, the insulated electrical component comprising a conducting element, an insulating material covering the conducting element, a first radiographically-visible conductor sensor node coupled to the conducting element, and at least one second radiographically-visible conductor sensor node coupled to the conducting element spaced a first distance in a predetermined direction from the first radiographically-visible conductor sensor node at the predetermined service age;
measuring the first distance in the predetermined direction from the first radiographically-visible conductor sensor node to the second radiographically-visible conductor sensor node from the first radiographic image; and
comparing the first distance to a second distance in the predetermined direction from the first radiographically-visible conductor sensor node to the second radiographically-visible conductor sensor node measured from a second radiographic image collected at a pre-service age to determine an occurrence of creep in the insulated electrical component; wherein the first distance being greater than the second distance indicates the occurrence of creep in the insulated electrical component.

2. The method of clause 1 further comprising collecting the second radiographic image of the insulated electrical component at the pre-service age and measuring the second distance from the first radiographically-visible conductor sensor node to the second radiographically-visible conductor sensor node from the second radiographic image.

3. The method of clause 1, wherein the at least one second radiographically-visible conductor sensor node comprises a plurality of second radiographically-visible conductor sensor nodes.

4. The method of clause 1, wherein the insulated electrical component further comprises a first radiographically-visible insulator sensor node coupled to the insulating material and not coupled to the conducting element and at least one second radiographically-visible insulator sensor node coupled to the insulating material and not coupled to the conducting element and located a third distance in the predetermined direction from the first radiographically-visible insulator sensor node at the predetermined service age, the method further comprising:

measuring the third distance in the predetermined direction from the first radiographically-visible insulator sensor node to the second radiographically-visible insulator sensor node from the first radiographic image; and
comparing the third distance to a fourth distance in the predetermined direction from the first radiographically-visible insulator sensor node to the second radiographically-visible insulator sensor node measured from the second radiographic image collected at the pre-service age to determine an occurrence of debonding in the insulated electrical component;
wherein a first difference between the first distance and the second distance being greater than a second difference between the third distance and the fourth distance indicates an occurrence of debonding of the insulating material from the conducting element in the insulated electrical component.

5. The method of clause 1 further comprising:

collecting a third radiographic image of the insulated electrical component of the predetermined service age, the insulated electrical component further comprising a first radiographically-visible insulator sensor node coupled to the insulating material and not coupled to the conducting element and at least one second radiographically-visible insulator sensor node coupled to the insulating material and not coupled to the conducting element and located a third distance in the predetermined direction from the first radiographically-visible insulator sensor node at the predetermined service age;
measuring the third distance in the predetermined direction from the first radiographically-visible insulator sensor node to the second radiographically-visible insulator sensor node from the third radiographic image; and
comparing the third distance to a fourth distance in the predetermined direction from the first radiographically-visible insulator sensor node to the second radiographically-visible insulator sensor node measured from a fourth radiographic image collected at the pre-service age;
wherein a first difference between the first distance and the second distance being greater than a second difference between the third distance and the fourth distance indicates an occurrence of debonding of the insulating material from the conducting element in the insulated electrical component.

6. The method of c clause 5 further comprising collecting the fourth radiographic image of the insulated electrical component at the pre-service age and measuring the fourth distance in the predetermined direction from the first radiographically-visible insulator sensor node to the second radiographically-visible insulator sensor node from the fourth radiographic image.

7. The method of clause 1, wherein the insulated electrical component is a high-voltage generator component.

8. A method of non-destructive testing, the method comprising:

collecting at least one radiographic image of an insulated electrical component of a predetermined service age, the insulated electrical component comprising a conducting element, an insulating material covering the conducting element, a first radiographically-visible conductor sensor node coupled to the conducting element, at least one second radiographically-visible conductor sensor node coupled to the conducting element spaced a first distance in a predetermined direction from the first radiographically-visible conductor sensor node at the predetermined service age, a first radiographically-visible insulator sensor node coupled to the insulating material and not coupled to the conducting element, and at least one second radiographically-visible insulator sensor node coupled to the insulating material and not coupled to the conducting element and located a second distance in the predetermined direction from the first radiographically-visible insulator sensor node at the predetermined service age; and
comparing the first distance to the second distance from the first radiographic image to determine an occurrence of debonding in the insulated electrical component;
wherein the first distance differing from the second distance indicates the occurrence of debonding in the insulated electrical component.

9. A method of manufacturing an insulated electrical component comprising:

coupling a first radiographically-visible conductor sensor node to a conducting element;
coupling at least one second radiographically-visible conductor sensor node to the conducting element a first distance in a predetermined direction from the first radiographically-visible conductor sensor node; and
bonding an insulating material to the conducting element and the radiographically-visible conductor sensor nodes;
wherein the radiographically-visible conductor sensor nodes are distinguishable from the conducting element and the insulating material in a radiographic image.

10. The method of clause 9, wherein coupling at least one second radiographically-visible conductor sensor node to the conducting element a first distance in a predetermined direction from the first radiographically-visible conductor sensor node comprises coupling a plurality of second radiographically-visible conductor sensor nodes to the conducting element a plurality of first distances in the predetermined direction from the first radiographically-visible conductor sensor node.

11. The method of clause 9 further comprising:

embedding a first radiographically-visible insulator sensor node in the insulating material; and
embedding at least one second radiographically-visible insulator sensor node in the insulating material a second distance in the predetermined direction from the first radiographically-visible insulator sensor node, wherein the radiographically-visible insulator sensor nodes are distinguishable from the conducting element and the insulating material in a radiographic image;
wherein the radiographically-visible insulator sensor nodes are not coupled to the conducting element.

12. The method of clause 11, wherein the first radiographically-visible conductor sensor node is located with respect to the first radiographically-visible insulator sensor node in the same manner as the second radiographically-visible conductor sensor node is located with respect to the second radiographically-visible insulator sensor node such that the first distance equals the second distance.

13. The method of clause 9, wherein the insulated electrical component is a high-voltage generator component.

14. An insulated electrical component comprising:

a conducting element;
a first radiographically-visible conductor sensor node coupled to the conducting element;
at least one second radiographically-visible conductor sensor node coupled to the conducting element a first distance in a predetermined direction from the first radiographically-visible conductor sensor node; and
an insulating material bonded to the conducting element;
wherein the first radiographically-visible conductor sensor node and the second radiographically-visible conductor sensor node are distinguishable from the conducting element and the insulating material in a radiographic image.

15. The insulated electrical component of clause 14, wherein the at least one second radiographically-visible conductor sensor node comprises a plurality of second radiographically-visible conductor sensor nodes.

16. The insulated electrical component of clause 14 further comprising:

a first radiographically-visible insulator sensor node coupled to the insulating material and not coupled to the conducting element; and
at least one second radiographically-visible insulator sensor node coupled to the insulating material and not coupled to the conducting element a second distance in the predetermined direction from the first radiographically-visible insulator sensor node;
wherein the first radiographically-visible insulator sensor node and the second radiographically-visible insulator sensor node are distinguishable from the conducting element and the insulating material in the radiographic image.

17. The insulated electrical component of clause 16, wherein the first radiographically-visible insulator sensor node and the second radiographically-visible insulator sensor node are embedded in the insulating material.

18. The insulated electrical component of clause 16, wherein the at least one second radiographically-visible insulator sensor node comprises a plurality of second radiographically-visible insulator sensor nodes.

19. The insulated electrical component of clause 14, wherein the insulating material is bonded to the conducting element.

20. The insulated electrical component of clause 14, wherein the conducting element comprises copper.

**Claims**

1.  A method of non-destructive testing, the method comprising:

    collecting a first radiographic image of an insulated electrical component (10) of a predetermined service age, the insulated electrical component (10) comprising a conducting element (12), an insulating material (14) covering the conducting element (12), a first radiographically-visible conductor sensor node (16) coupled to the conducting element (12), and at least one second radiographically-visible conductor sensor node (16) coupled to the conducting element (12) spaced a first distance in a predetermined direction from the first radiographically-visible conductor sensor node (16) at the predetermined service age;
    measuring the first distance in the predetermined direction from the first radiographically-visible conductor sensor node (16) to the second radiographically-visible conductor sensor node (16) from the first radiographic image; and
    comparing the first distance to a second distance in the predetermined direction from the first radiographically-visible conductor sensor node (16) to the second radiographically-visible conductor sensor node (16) measured from a second radiographic image collected at a pre-service age to determine an occurrence of creep in the insulated electrical component (10);
    wherein the first distance being greater than the second distance indicates the occurrence of creep in the insulated electrical component (10).

2.  The method of claim 1 further comprising collecting the second radiographic image of the insulated electrical component (10) at the pre-service age and measuring the second distance from the first radiographically-visible conductor sensor node (16) to the second radiographically-visible conductor sensor node (16) from the second radiographic image.

3.  The method of claim 1, wherein the at least one second radiographically-visible conductor sensor node (16) comprises a plurality of second radiographically-visible conductor sensor nodes (16).

4.  The method of claim 1, wherein the insulated electrical component (10) further comprises a first radiographically-visible insulator sensor node (40) coupled to the insulating material (14) and not coupled to the conducting element (12) and at least one second radiographically-visible insulator sensor node (40) coupled to the insulating material (14) and not coupled to the conducting element (12) and located a third distance in the predetermined direction from the first radiographically-visible insulator sensor node (40) at the predetermined service age, the method further comprising:

    measuring the third distance in the predetermined direction from the first radiographically-visible insulator sensor node (40) to the second radiographically-visible insulator sensor node (40) from the first radiographic image; and
    comparing the third distance to a fourth distance in the predetermined direction from the first radiographically-visible insulator sensor node (40) to the second radiographically-visible insulator sensor node (40) measured from the second radiographic image collected at the pre-service age to determine an occurrence of debonding (80) in the insulated electrical component (10);
    wherein a first difference between the first distance and the second distance being greater than a second difference between the third distance and the fourth distance indicates an occurrence of debonding (80) of the insulating material (14) from the conducting element (12) in the insulated electrical component (10).

5.  The method of claim 1 further comprising:

collecting a third radiographic image of the insulated electrical component (10) of the predetermined service age, the insulated electrical component (10) further comprising a first radiographically-visible insulator sensor node (40) coupled to the insulating material (14) and not coupled to the conducting element (12) and at least one second radiographically-visible insulator sensor node (40) coupled to the insulating material (14) and not coupled to the conducting element (12) and located a third distance in the predetermined direction from the first radiographically-visible insulator sensor node (40) at the predetermined service age;

measuring the third distance in the predetermined direction from the first radiographically-visible insulator sensor node (40) to the second radiographically-visible insulator sensor node (40) from the third radiographic image; and

comparing the third distance to a fourth distance in the predetermined direction from the first radiographically-visible insulator sensor node (40) to the second radiographically-visible insulator sensor node (40) measured from a fourth radiographic image collected at the pre-service age;

wherein a first difference between the first distance and the second distance being greater than a second difference between the third distance and the fourth distance indicates an occurrence of debonding (80) of the insulating material (14) from the conducting element (12) in the insulated electrical component (10).

6. The method of claim 5 further comprising collecting the fourth radiographic image of the insulated electrical component (10) at the pre-service age and measuring the fourth distance in the predetermined direction from the first radiographically-visible insulator sensor node (40) to the second radiographically-visible insulator sensor node (40) from the fourth radiographic image.

7. The method of claim 1, wherein the insulated electrical component (10) is a high-voltage generator component.

8. A method of non-destructive testing, the method comprising:

collecting at least one radiographic image of an insulated electrical component (10) of a predetermined service age, the insulated electrical component (10) comprising a conducting element (12), an insulating material (14) covering the conducting element (12), a first radiographically-visible conductor sensor node (16) coupled to the conducting element (12), at least one second radiographically-visible conductor sensor node (16) coupled to the conducting element (12) spaced a first distance in a predetermined direction from the first radiographically-visible conductor sensor node (16) at the predetermined service age, a first radiographically-visible insulator sensor node (40) coupled to the insulating material (14) and not coupled to the conducting element (12), and at least one second radiographically-visible insulator sensor node (40) coupled to the insulating material (14) and not coupled to the conducting element (12) and located a second distance in the predetermined direction from the first radiographically-visible insulator sensor node (40) at the predetermined service age; and

comparing the first distance to the second distance from the first radiographic image to determine an occurrence of debonding (80) in the insulated electrical component (10);

wherein the first distance differing from the second distance indicates the occurrence of debonding (80) in the insulated electrical component (10).

9. A method of manufacturing an insulated electrical component (10) comprising:

coupling a first radiographically-visible conductor sensor node (16) to a conducting element (12);

coupling at least one second radiographically-visible conductor sensor node (16) to the conducting element (12) a first distance in a predetermined direction from the first radiographically-visible conductor sensor node (16); and

bonding an insulating material (14) to the conducting element (12) and the radiographically-visible conductor sensor nodes (16);

wherein the radiographically-visible conductor sensor nodes (16) are distinguishable from the conducting element (12) and the insulating material (14) in a radiographic image.

10. The method of claim 9, wherein coupling at least one second radiographically-visible conductor sensor node (16) to the conducting element (12) a first distance in a predetermined direction from the first radiographically-visible conductor sensor node (16) comprises coupling a plurality of second radiographically-visible conductor sensor nodes (16) to the conducting element (12) a plurality of first distances in the predetermined direction from the first radiographically-visible conductor sensor node (16).

11. The method of claim 9 further comprising:

embedding a first radiographically-visible insulator sensor node (40) in the insulating material (14); and
embedding at least one second radiographically-visible insulator sensor node (40) in the insulating material (14) a second distance in the predetermined direction from the first radiographically-visible insulator sensor node (40), wherein the radiographically-visible insulator sensor nodes (40) are distinguishable from the conducting element (12) and the insulating material (14) in a radiographic image;
wherein the radiographically-visible insulator sensor nodes (40) are not coupled to the conducting element (12).

12. The method of claim 10, wherein the first radiographically-visible conductor sensor node (16) is located with respect to the first radiographically-visible insulator sensor node (40) in the same manner as the second radiographically-visible conductor sensor node (16) is located with respect to the second radiographically-visible insulator sensor node (40) such that the first distance equals the second distance.

13. An insulated electrical component (10) comprising:

a conducting element (12);
a first radiographically-visible conductor sensor node (16) coupled to the conducting element (12);
at least one second radiographically-visible conductor sensor node (16) coupled to the conducting element (12) a first distance in a predetermined direction from the first radiographically-visible conductor sensor node (16); and
an insulating material (14) bonded to the conducting element (12);
wherein the first radiographically-visible conductor sensor node (16) and the second radiographically-visible conductor sensor node (16) are distinguishable from the conducting element (12) and the insulating material (14) in a radiographic image.

14. The insulated electrical component (10) of claim 13, wherein the at least one second radiographically-visible conductor sensor node (16) comprises a plurality of second radiographically-visible conductor sensor nodes (16).

15. The insulated electrical component (10) of claim 13 further comprising:

a first radiographically-visible insulator sensor node (40) coupled to the insulating material (14) and not coupled to the conducting element (12); and
at least one second radiographically-visible insulator sensor node (40) coupled to the insulating material (14) and not coupled to the conducting element (12) a second distance in the predetermined direction from the first radiographically-visible insulator sensor node (40);
wherein the first radiographically-visible insulator sensor node (40) and the second radiographically-visible insulator sensor node (40) are distinguishable from the conducting element (12) and the insulating material (14) in the radiographic image.

FIG. 1

FIG. 2

FIG. 3

FIG. 4

**FIG. 5**

**FIG. 6**

**FIG. 7**

**FIG. 8**

**FIG. 9**

**FIG. 10**

**FIG. 12**

**FIG. 11**

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/212140 A1 (LAWRENCE MICHAEL E [US] ET AL) 30 July 2015 (2015-07-30) | 13,14 | INV. G01N23/04 H01B13/34 |
| A | * paragraph [0046]; figure 6 * | 15 | |
| A | JP 2003 254916 A (BABCOCK HITACHI KK) 10 September 2003 (2003-09-10) * paragraph [0008] - paragraph [0011]; figures * | 1-15 | |
| A | EP 1 418 437 A1 (ALSTOM TECHNOLOGY LTD [CH]) 12 May 2004 (2004-05-12) * paragraph [0002] - paragraph [0010] * * paragraph [0015] * | 1-15 | |
| A | EP 2 778 645 A1 (GEN ELECTRIC [US]) 17 September 2014 (2014-09-17) * paragraph [0019] - paragraph [0022] * | 1-15 | |
| A | US 2005/134837 A1 (SARKOZI JANOS G [US] ET AL) 23 June 2005 (2005-06-23) * paragraph [0034]; figure 3 * | 1-15 | |

TECHNICAL FIELDS
SEARCHED (IPC)

G01N
H01B

The present search report has been drawn up for all claims

| Place of search | Date of completion of the search | Examiner |
|---|---|---|
| The Hague | 21 August 2017 | Savage, John |

EPO FORM 1503 03.82 (P04C01)

## ANNEX TO THE EUROPEAN SEARCH REPORT
## ON EUROPEAN PATENT APPLICATION NO.

EP 17 17 6924

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2017

| Patent document cited in search report | | Publication date | Patent family member(s) | | Publication date |
|---|---|---|---|---|---|
| US 2015212140 | A1 | 30-07-2015 | CA<br>EP<br>US<br>WO | 2935243 A1<br>3100061 A1<br>2015212140 A1<br>2015116723 A1 | 06-08-2015<br>07-12-2016<br>30-07-2015<br>06-08-2015 |
| JP 2003254916 | A | 10-09-2003 | JP<br>JP | 3998053 B2<br>2003254916 A | 24-10-2007<br>10-09-2003 |
| EP 1418437 | A1 | 12-05-2004 | NONE | | |
| EP 2778645 | A1 | 17-09-2014 | EP<br>JP<br>US | 2778645 A1<br>2014196739 A<br>2014267677 A1 | 17-09-2014<br>16-10-2014<br>18-09-2014 |
| US 2005134837 | A1 | 23-06-2005 | DE<br>GB<br>JP<br>JP<br>US | 102004051734 A1<br>2409516 A<br>4659431 B2<br>2005181294 A<br>2005134837 A1 | 28-07-2005<br>29-06-2005<br>30-03-2011<br>07-07-2005<br>23-06-2005 |

EPO FORM P0459

For more details about this annex : see Official Journal of the European Patent Office, No. 12/82